# EUROPÄISCHE PATENTSCHRIFT

(11) **EP 1 596 499 B1**
(45) Veröffentlichungstag und Bekanntmachung des Hinweises auf die Patenterteilung: **14.11.2007**
(21) Anmeldenummer: 05009638.7
(22) Anmeldetag: 03.05.2005
(51) Int. Cl.: H03K 17/96

(54) **Berührungsempfindlicher Tastschalter**
Touch sensitive key switch device
Commutateur à touche tactile

(30) Priorität: 12.05.2004 DE 102004023416; 27.05.2004 DE 102004025878
(43) Veröffentlichungstag der Anmeldung: 16.11.2005
(73) Patentinhaber: Diehl AKO Stiftung & Co. KG, 88239 Wangen (DE)
(72) Erfinder: Arnold, Georg, 91126 Schwabach (DE)
(74) Vertreter: Diehl Patentabteilung

(56) Entgegenhaltungen:
- EP-A- 0 446 642
- EP-A- 0 558 871
- EP-A- 1 406 387
- DE-A1- 10 211 307
- DE-C1- 19 700 836
- GB-A- 2 133 137
- US-A- 4 405 197

## Beschreibung

Die vorliegende Erfindung betrifft einen berührungsempfindlichen Tastschalter nach dem Oberbegriff des Patentanspruchs 1, und insbesondere einen solchen Infrarot-Tastschalter zur Verwendung in einer Bedienungseinrichtung eines Haushaltsgeräts.

Der grundsätzliche Aufbau und das Grundprinzip eines solchen berührungsempfindlichen Tastschalters sind zum Beispiel aus der DE 40 07 971 A1 bekannt. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Eine vorteilhafte Anwendung derartiger berührungsempfindlicher Tastschalter ist zum Beispiel der Einsatz in Bedieneinrichtungen von Haushaltsgeräten, wie Kochherden, Glaskeramik-Kochfeldern, Mikrowellenherden und dergleichen, bei denen der Tastschalter, damit er einfach zu bedienen und auch zu reinigen ist, hinter einer Abdeckung, wie beispielsweise einer Glasplatte oder Glaskeramikplatte untergebracht ist.

Ein solcher berührungsempfindlicher Tastschalter ist auch aus der DE 197 00 836 C1 bekannt. Dort ist sowohl dem Sender als auch dem Empfänger der elektromagnetischen Strahlung jeweils ein eigenes Lichtleitelement zugeordnet, dessen dem Sender bzw. Empfänger abgewandtes Ende mit dem Ende des anderen Lichtleitelements benachbart und an die Abdeckung angrenzend vorgesehen sind.

In diesem Zusammenhang ist es zum Beispiel aus der DE 102 11 307 A1 auch bekannt, dem Sender und Empfänger einen Lichtleiter zuzuordnen, der entweder selbst die Abdeckung bildet oder hinter einer Abdeckung angeordnet werden kann. Durch die Verwendung des Lichtleiters lassen sich die Anordnungsfreiheitsgrade der optoelektronischen Bauelemente auf einer Trägerplatine und auch der Tastenfelder auf der Abdeckung gegenüber Tastschalteraufbauten ohne Lichtleiter vergrößern.

Ferner beschreibt das deutsche Gebrauchsmuster DE 202 15 326 U1 der Anmelderin einen berührungsempfindlichen Tastschalter, der zusätzlich eine Signalisierungsleuchte aufweist, welche dem Benutzer zum Beispiel die Betriebsbereitschaft oder die erfolgte Bedienung des Tastschalters anzeigen kann.

Der vorliegenden Erfindung liegt die Aufgabe zugrunde, einen berührungsempfindlichen Tastschalter der eingangs genannten Art bereit zu stellen, der ein verbessertes Nutzsignal/Störsignal-Verhältnis besitzt.

Diese Aufgabe wird durch einen berührungsempfindlichen Tastschalter mit den Merkmalen des Anspruchs 1 gelöst. Vorteilhafte Ausgestaltungen und Weiterbildungen der Erfindung sind Gegenstand der abhängigen Ansprüche.
Der berührungsempfindliche Tastschalter weist einen Infrarot-Strahlung aussendenden Sender und einen Infrarot-Strahlung empfangenden Empfänger auf, die hinter einer für die elektromagnetische Strahlung zumindest teildurchlässigen Abdeckung angeordnet sind, wobei dem Sender ein erstes Lichtleitelement zugeordnet ist und dem Empfänger ein zweites Lichtleitelement zugeordnet ist, deren dem Sender bzw. Empfänger abgewandte Enden einander benachbart und angrenzend an die Abdeckung vorgesehen sind, wobei das erste und das zweite Lichtleitelement an ihren dem Sender bzw. Empfänger abgewandte Enden im Verhältnis zu ihren dem Sender bzw. Empfänger zugewandte Enden aufgeweitet sind.

Gemäß der vorliegenden Erfindung ist dem Sender und dem Empfänger des berührungsempfindlichen Tastschalters jeweils ein eigenes Lichtleitelement zugeordnet. Hierdurch sind der Lichtweg zwischen Sender und Abdeckung und der Lichtweg zwischen Abdeckung und Empfänger entkoppelt, wodurch verhindert wird, dass die an der Grenzschicht zwischen dem ersten Lichtleitelement und der Abdeckung von der von dem Sender ausgesendeten Strahlung entstehende Reflexionsstrahlung als Störlicht zu dem Empfänger gelangt, da sie nicht in das zweite Lichleitelement eindringen kann. Daher wird das Nutzlicht/Störlicht-Verhältnis des Tastschalters effizient verbessert.

Ein weiterer Vorteil des erfindungsgemäßen Tastschalters liegt in der vergrößerten Anordnungsfreiheit der optoelektronischen Bauelemente und der Tastenfelder auf der Abdeckung, da durch die Zwischenschaltung des ersten und des zweiten Lichtleitelements die Positionen des Senders und Empfängers nicht der des Tastenfeldes auf der Abdeckung entsprechen müssen und grundsätzliche beliebige Abstände zwischen dem Sender / Empfänger und der Abdeckung möglich sind. Selbst der Sender und der Empfänger eines Tastschalters müssen nicht notwendigerweise angrenzend zueinander angeordnet sein.

Infolge der Ausgestaltung der Erfindung, nämlich dadurch, dass das erste und das zweite Lichtleitelement an ihren dem Sender bzw. Empfänger abgewandten Enden im Verhältnis zu ihren dem Sender bzw. Empfänger zugewandten Enden aufgeweitet ist, kann ein vergrößertes Tastenfeld auf der Abdeckung erzielt werden.

In einer bevorzugten Ausführungsform der Erfindung ist zwischen dem ersten und dem zweiten Lichtleitelement einerseits und der Abdeckung andererseits ein dunkles Filterelement angeordnet. Alternativ oder zusätzlich können auch das erste und das zweite Lichtleitelement dunkel eingefärbt sein. Durch diese Maßnahme wird ermöglicht, dass der Tastschalter bei ausgeschaltetem Gerät bzw. bei Nicht-Betriebsbereitschaft für den Benutzer nicht erkennbar ist und man so ein optisch ansprechendes Design des Geräts erhält.

Durch die weitere Ausgestaltung der Erfindung, nämlich dadurch dass die Lichtleitelemente komplett oder an den der Abdeckung zugewandten Enden diffus ausgebildet sind, beispielsweise aufgeraut, sind diese Licht diffus streuend ausgebildet, wodurch erreicht wird, dass das Tastenfeld gleichmäßig ausleuchtbar ist.

In einer Ausgestaltung der Erfindung verlaufen das erste und das zweite Lichtleitelement im Wesentlichen parallel zueinander und/oder im Wesentlichen senkrecht zu der Abdeckung und geradlinig zwischen der Abdeckung und dem Sender bzw. Empfänger. Grundsätzlich können die beiden Lichtleitelemente aber beliebig angeordnet werden, um die Anordnungsfreiheitsgrade der optoelektronischen Bauelemente und der Tastenfelder auf der Abdeckung zu vergrößern. Werden die Lichtleiterelemente parallel angeordnet, können diese auf kleinem Abstand zueinander gehalten werden, indem die Lichtleiter kleine Noppen oder Rillen (in einer Größenordnung von z.B. 0,2 mm) aufweisen.

In einer weiteren vorteilhaften Ausgestaltung der Erfindung weist der Tastschalter ferner wenigstens ein sichtbares Licht aussendendes Signalelement auf, das dem ersten und/oder dem zweiten Lichtleitelement auf der dem Sender bzw. Empfänger zugewandten Seite des Lichtleitelements zugeordnet ist, und mit welchem einem Benutzer zum Beispiel eine Betriebsbereitschaft oder eine erfolgte Bedienung des Tastschalters angezeigt werden können.

Hierbei ist das wenigstens eine Signalelement beispielsweise eine Leuchtdiode, welche bevorzugt sowohl dem ersten Lichtleitelement als auch dem zweiten Lichteitelement zugeordnet ist, indem sie zum Beispiel zwischen dem Sender und dem Empfänger angeordnet ist. Es können auch mehrere gleichfarbige oder verschieden farbige Leuchtdioden vorgesehen sein.

Der Sender, der Empfänger und das wenigstens eine Signalelement sind bevorzugt auf einer gemeinsamen Trägerplatine angeordnet.

Vorzugsweise ist der Tastschalter ferner wenigstens im Bereich des Senders und des Empfängers von einer Blende zur Abschirmung gegen Fremdlicht umgeben, um das Nutzlicht/Störlicht-Verhältnis weiter zu verbessern.

Der oben beschriebene berührungsempfindliche Tastschalter der Erfindung ist besonders vorteilhaft in einer Bedieneinrichtung für ein elektronisches Haushaltsgerät, wie beispielsweise einen Kochherd, einen Mikrowellenherd, ein Kochfeld, eine Waschmaschine, einen Wäschetrockner, eine Spülmaschine und dergleichen, einsetzbar. Hierbei können auch mehrere berührungsempfindliche Tastschalter zu einem Tastenelement kombiniert werden.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:
- Fig. 1: eine schematische Seitenansicht eines berührungsempfindlichen Tastschalters gemäß einem bevorzugten Ausführungsbeispiel der vorliegenden Erfindung; und
- Fig. 2: eine schematische Seitenansicht gemäß Ansicht A in Fig. 1 einer Modifikation des berührungsempfindlichen Tastschalters von Fig. 1.

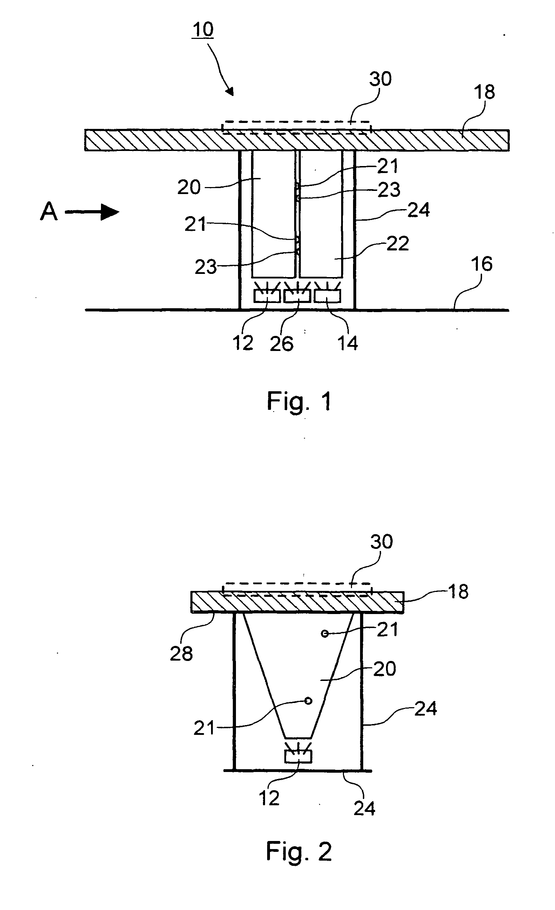

Anhand der Fig. 1 und 2 wird nachfolgend ein bevorzugtes Ausführungsbeispiel eines berührungsempfindlichen Tastschalters der Erfindung am Beispiel eines Infrarot-Tastschalters für ein Haushaltsgerät, wie einen Kochherd, einen Mikrowellenherd, ein Kochfeld, eine Waschmaschine, einen Wäschetrockner, eine Spülmaschine oder dergleichen, erläutert, ohne dass die Erfindung auf eine elektromagnetische Strahlung dieses Wellenlängenbereichs oder diese spezielle Anwendung beschränkt ist.

Der berührungsempfindliche Tastschalter 10 weist einen Infrarot-Sender 12 und einen Infrarot-Empfänger 14 auf, die auf einer Trägerplatine 16 montiert und hinter einer für Infrarot-Strahlung zumindest teildurchlässigen Abdeckung 18, wie beispielsweise einer Glasplatte oder Glaskeramikplatte, angeordnet sind. Während der Sender 12 und der Empfänger 14 an einander benachbarten Positionen auf der Trägerplatine 16 angeordnet sind, ist die vorliegende Erfindung nicht auf diese Anordnung beschränkt; vielmehr können der Sender 12 und der Empfänger 14 grundsätzlich voneinander unabhängig auf der Trägerplatine 16 positioniert werden. Außerdem müssen der Sender 12 und der Empfänger 14 nicht notwendigerweise entsprechend einem Tastenfeld 30 der Abdeckung 18 für den Benutzer hinter der Abdeckung angeordnet sein, wie in Fig. 1 und 2 dargestellt, sondern können grundsätzlich ebenfalls unabhängig von der Positionierung des Tastenfeldes 30 an für die Montage günstigen Stellen vorgesehen sein. Des weiteren ist der Abstand zwischen der Abdeckung 18 und dem Sender 12 und dem Empfänger 14 grundsätzlich beliebig klein und auch beliebig groß wählbar. Dies ist insbesondere von Vorteil, falls der Abstand bedingt durch zum Beispiel andere Bauelemente auf der Trägerplatine 16 relativ groß gewählt werden muss.

Dem Infrarot-Sender 12 ist ein erstes Lichtleitelement 20 zugeordnet, dessen dem Sender 12 abgewandtes Ende angrenzend an die Abdeckung 18 vorgesehen ist. Analog ist dem Infrarot-Empfänger 14 ein zweites Lichtleitelement 22 zugeordnet, dessen dem Empfänger 14 abgewandtes Ende ebenfalls angrenzend an die Abdeckung 18 vorgesehen ist. Die beiden Lichtleitelemente 20, 22 weisen an ihren dem jeweils anderen Lichtleitelement 22, 20 zugewandten Seitenflächen eine Anzahl von aus dem Material der Lichtleitelemente 20, 22 ausgebildete Noppen 21, 23 auf (in Fig. 2 durch das Lichtleitelement 20 hindurch sichtbar), die eine Erhebung von etwa 0,2 mm in den Seitenflächen der Lichtleitelemente 20, 22 bilden und diese so auf Abstand halten, wodurch eine unerwünschte optische Kopplung zwischen den Lichtleitelementen 20, 22 vermieden wird.

Außerdem sind die dem Sender 12 bzw. dem Empfänger 14 angewandten Enden des ersten und des zweiten Lichtleitelements 20 und 22 einander benachbart angeordnet. Das von dem Sender 12 ausgesendete Licht wird durch das erste Lichtleitelement 20 und die Abdeckung 18 nach außen abgestrahlt; befindet sich ein Finger eines Benutzers im Bereich des Tastenfeldes 30 auf der Abdeckung 18, so wird dieses Licht von dem Finger reflektiert und durch die Abdeckung 18 und das zweite Lichtleitelement 22 zu dem Empfänger 14 geleitet, um das Signal auszuwerten.

Durch die zwei separaten Lichtleitelemente 20 und 22 für den Sender 12 und den Empfänger 14 des Tastschalters 10 kann das von dem Sender 12 ausgesendete und an der Grenzschicht zwischen dem ersten Lichtleitelement 20 und der Abdeckung 18 reflektierte Licht nicht als Störlicht auf den Empfänger 14 treffen. So kann das Nutzlicht/Störlicht-Verhältnis des Tastschalters 10 effizient verbessert werden. Eine gegenseitige Störung des in den beiden Lichtleitelementen 20, 22 laufenden Lichts ist bei einer ausreichenden Qualität der Lichtleitelemente, ggf. zusätzlich durch eine geeignete Ummantelung sichergestellt, ausgeschlossen.

Wie in der Seitenansicht von Fig. 2 zu erkennen, ist das dem Sender 12 bzw. dem Empfänger 14 abgewandte Ende der Lichtleitelemente 20 und 22 gegenüber dem dem Sender bzw. dem Empfänger zugewandten Ende jeweils aufgeweitet. Auf diese Weise kann ein relativ großes Tastenfeld 30 auf der Abdeckung 18 erzeugt werden, das von dem Benutzer einfach zu bedienen ist. Hierbei sind die Lichtleitelemente 20, 22 bevorzugt so ausgestaltet, dass sich eine möglichst gleichmäßige Ausleuchtung des Tastenfeldes 30 ergibt. Zu diesem Zweck können die Lichtleiter komplett oder die der Abdeckung 18 zugewandten Enden der Lichtleitelemente 20, 22 diffus ausgebildet, zum Beispiel aufgeraut sein.

In dem gezeigten Ausführungsbeispiel verlaufen die beiden Lichtleitelemente 20 und 22 im Wesentlichen senkrecht zu der Abdeckung 18, im Wesentlichen parallel zueinander, und im Wesentlichen geradlinig zwischen der Abdeckung 18 und dem Sender 12 bzw. dem Empfänger 14. Die vorliegende Erfindung ist aber nicht nur auf diese Anordnung der Lichtleitelemente beschränkt; vielmehr können das erste und das zweite Lichtleitelement 20 und 22 unabhängig voneinander und in einem grundsätzlich beliebigen Verlauf angeordnet sein, was den Anordnungsfreiheitsgrad für die optoelektronischen Bauelemente auf der Trägerplatine vergrößert.

Obwohl nicht dargestellt, ist es außerdem möglich, dass das erste Lichtleitelement 20 an seinem dem Infrarot-Sender 12 zugewandten Ende ein Strahlungseinkopplungselement aufweist und das zweite Lichtleitelement 22 an seinem dem Infrarot-Empfänger 14 zugewandten Ende ein Strahlungsauskopplungselement aufweist, um die Einkopplung und Auskopplung der Infrarot-Strahlung in das erste Lichtleitelement 20 bzw. aus dem zweiten Lichtleitelement 22 zu optimieren und damit die Empfindlichkeit des Tastschalters 10 zu erhöhen.

Wie in der Modifikation des ersten Ausführungsbeispiels in Fig. 2 dargestellt, kann zwischen der Abdeckung 18 und dem ersten und dem zweiten Lichtleitelement 20, 22 ein dunkler Filter 28 vorgesehen sein. Alternativ oder zusätzlich können auch das erste und das zweite Lichtleitelement 20, 22 dunkel eingefärbt sein. Hierdurch ist es möglich, dass der Tastschalter 10 bei ausgeschaltetem Haushaltsgerät bzw. bei Nicht-Betriebsbereitschaft für den Benutzer nicht erkennbar ist und daher ein optisch ansprechendes Design des Haushaltsgeräts erzielt werden kann.

Um das Nutzlicht/Störlicht-Verhältnis des berührungsempfindlichen Tastschalters 10 weiter zu verbessern, ist der Tastschalter 10 von einer Blende 24 umgeben, wie in Fig. 1 veranschaulicht, um den Tastschalter 10 gegen Fremdlichteinfall abzuschirmen. Hierbei sollte die Blende 24 zumindest im Bereich des Senders 12 und des Empfängers 14 vorgesehen sein.

Ferner weist der berührungsempfindliche Tastschalter 10 wenigstens eine Leuchtdiode 26 zum Aussenden von sichtbarem Licht als Signalelement der Erfindung auf. Wahlweise können auch mehrere, selektiv gleichfarbige oder verschieden farbige Leuchtdioden 26 vorgesehen sein.

Wie in Fig. 1 dargestellt, ist die wenigstens eine Leuchtdiode 26 derart zwischen dem Infrarot-Sender 12 und dem Infrarot-Empfänger 14 auf der gemeinsamen Trägerplatine 16 montiert, dass die wenigstens eine Leuchtdiode 26 sowohl dem ersten Lichtleitelement 20 als auch dem zweiten Lichtleitelement 22 zugeordnet ist, sodass das von der wenigstens einen Leuchtdiode 26 ausgesendete sichtbare Licht durch beide Lichtleitelemente 20, 22 durch die Abdeckung 18 nach außen gesendet wird. Im Fall von mehreren Leuchtdioden 26 kann jeweils auch eine Leuchtdiode 26 in nur eines der Lichtleitelemente 20, 22 strahlen.

Durch diese Anordnung des wenigstens einen Signalelements 26 ist es zum Beispiel möglich, den Tastschalter 10 bzw. das Tastenfeld 30 auf der Abdeckung 18 von hinten zu beleuchten und so für den Benutzer sichtbar zu machen bzw. zu markieren. So kann beispielsweise eine Betriebsbereitschaft des Tastschalters 10 durch ein rotes Licht angezeigt werden, und eine durch den Benutzer erfolgte Bedienung des Tastschalters 10 wird dann durch ein grünes Licht angezeigt. Hierbei ist der Tastschalter 10, wie oben erwähnt, vorteilhafterweise nur bei eingeschaltetem Haushaltsgerät bzw. betriebsbereitem Tastschalter 10 für den Benutzer erkennbar.

Die Leuchtdiode 26 zwischen dem Sender 12 und dem Empfänger 14 bewirkt außerdem eine zusätzliche Abschirmung zwischen diesen beiden Bauelementen, sodass von dem Sender 12 ausgesendetes Licht nicht direkt als Störlicht auf den Empfänger 14 treffen kann. Das Nutzlicht/Störlicht-Verhältnis des Tastschalters 10 ist so weiter verbessert. Im Fall einer Ausführungsform des Tastschalters 10, bei dem kein Signalelement 26 zwischen dem Sender 12 und dem Empfänger 14 angeordnet ist, kann zum Zwecke der Abschirmung zwischen Sender und Empfänger statt dessen ein geeignetes Blendenelement vorgesehen sein, um den obigen Effekt zu erzielen.

### BEZUGSZIFFERNLISTE

- 10: Tastschalter
- 12: Sender
- 14: Empfänger
- 16: Trägerplatine
- 18: Abdeckung
- 20: erstes Lichtleitelement
- 22: zweites Lichtleitelement
- 24: Blende
- 26: Leuchtdiode
- 28: Filter
- 30: Tastenfeld

## Patentansprüche

1. Berührungsempfindlicher Tastschalter (10), mit einem Infrarot-Strahlung aussendenden Sender (12) und einem Infrarot-Strahlung empfangenden Empfänger (14), die hinter einer für die elektromagnetische Strahlung zumindest teildurchlässigen Abdeckung (18) angeordnet sind,
wobei dem Sender (12) ein erstes Lichtleitelement (20) zugeordnet ist und dem Empfänger (14) ein zweites Lichtleitelement (22) zugeordnet ist, deren dem Sender bzw. Empfänger abgewandte Enden einander benachbart und angrenzend an die Abdeckung (18) vorgesehen sind,
**dadurch gekennzeichnet,**
**dass** das erste und das zweite Lichtleitelement (20, 22) an ihren dem Sender bzw. Empfänger abgewandte Enden im Verhältnis zu ihren dem Sender bzw. Empfänger zugewandte Enden aufgeweitet sind.

2. Tastschalter nach Anspruch 1, **dadurch gekennzeichnet, dass** zwischen dem ersten und dem zweiten Lichtleitelement (20, 22) und der Abdeckung (18) ein dunkles Filterelement (28) angeordnet ist.

3. Tastschalter nach einem der vorhergehenden Ansprüche, **dadurch gekennzeichnet, dass** das erste und/oder das zweite Lichtleitelement (20, 22) dunkel eingefärbt sind.

4. Tastschalter nach einem der vorhergehenden Ansprüche, **dadurch gekennzeichnet, dass** das erste und/oder das zweite Lichtleitelement (20, 22) komplett oder an ihren den Sender bzw. Empfänger abgewandten Enden Licht diffus streuend ausgebildet sind.

5. Tastschalter nach einem der vorhergehenden Ansprüche, **dadurch gekennzeichnet, dass** das erste und das zweite Lichtleitelement (20, 22) im Wesentlichen parallel zueinander verlaufen.

6. Tastschalter nach einem der vorhergehenden Ansprüche, **dadurch gekennzeichnet, dass** das erste und das zweite Lichtleitelement (20, 22) im Wesentlichen senkrecht zu der Abdeckung (18) und im Wesentlichen geradlinig zwischen der Abdeckung (18) und dem Sender bzw. Empfänger verlaufen.

7. Tastschalter nach einem der vorhergehenden Ansprüche, **dadurch gekennzeichnet, dass** der Tastschalter (10) ferner wenigstens ein sichtbares Licht aussendendes Signalelement (26) aufweist, das dem ersten und/oder dem zweiten Lichtleitelement (20, 22) auf der dem Sender bzw. Empfänger zugewandten Seite des Lichtleitelements zugeordnet ist.

8. Tastschalter nach Anspruch 7, **dadurch gekennzeichnet, dass** das wenigstens eine Signalelement (26) eine Leuchtdiode ist.

9. Tastschalter nach Anspruch 7 oder 8, **dadurch gekennzeichnet, dass** das wenigstens eine Signalelement (26) sowohl dem ersten Lichtleitelement (20) als auch dem zweiten Lichtleitelement (22) zugeordnet ist.

10. Tastschalter nach Anspruch 7, **dadurch gekennzeichnet, dass** das wenigstens eine Signalelement (26) zwischen dem Sender (12) und dem Empfänger (14) angeordnet ist.

11. Tastschalter nach einem der Ansprüche 7 bis 10, **dadurch gekennzeichnet, dass** mehrere gleichfarbige oder verschieden farbige Signalelemente (26) vorgesehen sind.

12. Tastschalter nach einem der Ansprüche 7 bis 11, **dadurch gekennzeichnet, dass** der Sender (12), der Empfänger (14) und das wenigstens eine Signalelement (26) auf einer gemeinsamen Trägerplatine (16) angeordnet sind.

13. Tastschalter nach einem der vorhergehenden Ansprüche, **dadurch gekennzeichnet, dass** der Tastschalter (10) ferner wenigstens im Bereich des Senders (12) und/oder des Empfängers (14) von einer Blende (24) zur Abschirmung gegen Fremdlicht umgeben ist.

14. Bedieneinrichtung für ein elektronisches Haushaltsgerät mit wenigstens einem berührungsempfindlichen Tastschalter nach einem der Ansprüche 1 bis 13.

15. Bedieneinrichtung nach Anspruch 14, **dadurch gekennzeichnet, dass** mehrere berührungsempfindliche Tastschalter nach einem der Ansprüche 1 bis 13 zu einem Tastenelement kombiniert sind.

## Claims

1. Touch-sensitive momentary-contact switch (10) having a transmitter (12) which emits infrared radiation and a receiver (14) which receives infrared radiation, this transmitter and receiver being arranged behind a cover (18) through which some of the electromagnetic radiation passes,
wherein the transmitter (12) has an associated first optical fibre element (20) and the receiver (14) has an associated second optical fibre element (22), the ends of these optical fibre elements which face away from the transmitter and receiver, respectively, being adjacent to one another and adjoining the cover (18)
**characterized in that**,
in relation to their ends which face the transmitter and receiver respectively, the first and the second optical fibre element (20, 22) are widened at their ends which face away from the transmitter and receiver respectively.

2. Momentary-contact switch according to Claim 1, **characterized in that** a dark filter element (28) is arranged between the first and the second optical fibre element (20, 22) and the cover (18).

3. Momentary-contact switch according to one of the preceding claims, **characterized in that** the first and/or the second optical fibre element (20, 22) are/is darkened.

4. Momentary-contact switch according to one of the preceding claims, **characterized in that** the first and/or the second optical fibre element (20, 22) are formed so as to scatter light diffusely, in their entirety or at their ends which face away from the transmitter or receiver.

5. Momentary-contact switch according to one of the preceding claims, **characterized in that** the first and the second optical fibre element (20, 22) extend essentially parallel to one another.

6. Momentary-contact switch according to one of the preceding claims, **characterized in that** the first and the second optical fibre element (20, 22) extend essentially perpendicular to the cover (18) and essentially rectilinearly between the cover (18) and the transmitter or receiver respectively.

7. Momentary-contact switch according to one of the preceding claims, **characterized in that** the momentary-contact switch (10) also has at least one indicating element (26) which emits visible light and is associated with the first and/or with the second optical fibre element (20, 22) on that side of the optical fibre element which faces the transmitter or receiver respectively.

8. Momentary-contact switch according to Claim 7, **characterized in that** the at least one indicating element (26) is a light-emitting diode.

9. Momentary-contact switch according to Claim 7 or 8, **characterized in that** the at least one indicating element (26) is associated with both the first optical fibre element (20) and the second optical fibre element (22).

10. Momentary-contact switch according to Claim 7, **characterized in that** the at least one indicating element (26) is arranged between the transmitter (12) and the receiver (14).

11. Momentary-contact switch according to one of Claims 7 to 10, **characterized in that** a plurality of identically coloured or differently coloured indicating elements (26) are provided.

12. Momentary-contact switch according to one of Claims 7 to 11, **characterized in that** the transmitter (12), the receiver (14) and the at least one indicating element (26) are arranged on a common mounting board (16).

13. Momentary-contact switch according to one of the preceding claims, **characterized in that** the momentary-contact switch (10) is also surrounded by a screen (24) for screening it from external light, at least in the region of the transmitter (12) and/or of the receiver (14).

14. Control device for an electronic domestic appliance having at least one touch-sensitive momentary-contact switch according to one of Claims 1 to 13.

15. Control device according to Claim 14, **characterized in that** a plurality of touch-sensitive momentary-contact switches according to one of Claims 1 to 13 are combined to form a touch-operated element.

## Revendications

1. Commutateur à touche tactile (10), avec un émetteur (12) émettant un rayonnement infrarouge et un récepteur (14) recevant un rayonnement infrarouge, qui sont disposés derrière un couvercle (18) au moins partiellement transparent pour un rayonnement électromagnétique, dans lequel un premier élément de guide de lumière (20) est associé à l'émetteur (12) et un deuxième élément de guide de lumière (22) est associé au récepteur (14), dont les extrémités situées à l'opposé de l'émetteur ou du récepteur sont voisines l'une de l'autre et adjacentes au couvercle (18), **caractérisé en ce que** le premier et le deuxième éléments de guide de lumière (20, 22) sont élargis à leurs extrémités situées à l'opposé de l'émetteur ou du récepteur par rapport à leurs extrémités tournées vers l'émetteur ou le récepteur.

2. Commutateur à touche selon la revendication 1, **caractérisé en ce qu'**un élément de filtre sombre (28) est disposé entre le premier et le deuxième éléments de guide de lumière (20, 22) et le couvercle (18).

3. Commutateur à touche selon l'une quelconque des revendications précédentes, **caractérisé en ce que** le premier et/ou le deuxième élément de guide de lumière (20, 22) est de teinte foncée.

4. Commutateur à touche selon l'une quelconque des revendications précédentes, **caractérisé en ce que** le premier et/ou le deuxième élément de guide de lumière (20, 22) provoque une diffusion de la lumière complètement ou à leurs extrémités situées à l'opposé de l'émetteur ou du récepteur.

5. Commutateur à touche selon l'une quelconque des revendications précédentes, **caractérisé en ce que** le premier et le deuxième éléments de guide de lumière (20, 22) sont essentiellement parallèles l'un à l'autre.

6. Commutateur à touche selon l'une quelconque des revendications précédentes, **caractérisé en ce que** le premier et le deuxième éléments de guide de lumière (20, 22) sont essentiellement perpendiculaires au couvercle (18) et essentiellement rectilignes entre le couvercle (18) et l'émetteur ou le récepteur.

7. Commutateur à touche selon l'une quelconque des revendications précédentes, **caractérisé en ce que** le commutateur à touche (10) comprend en outre un élément de signalisation (26) émettant une lumière visible, qui est associé au premier et/ou au deuxième élément de guide de lumière (20, 22) sur le côté de l'élément de guide de lumière tourné vers l'émetteur ou le récepteur.

8. Commutateur à touche selon la revendication 7, **caractérisé en ce que** ledit au moins un élément de signalisation (26) est une diode électroluminescente.

9. Commutateur à touche selon la revendication 7 ou 8, **caractérisé en ce que** ledit au moins un élément de signalisation (26) est associé aussi bien au premier élément de guide de lumière (20) qu'au deuxième élément de guide de lumière (22).

10. Commutateur à touche selon la revendication 7, **caractérisé en ce que** ledit au moins un élément de signalisation (26) est disposé entre l'émetteur (12) et le récepteur (14).

11. Commutateur à touche selon l'une quelconque des revendications 7 à 10, **caractérisé en ce qu'**il est prévu plusieurs éléments de signalisation (26) de même couleur ou de couleurs différentes.

12. Commutateur à touche selon l'une quelconque des revendications 7 à 11, **caractérisé en ce que** l'émetteur (12), le récepteur (14) et ledit au moins un élément de signalisation (26) sont disposés sur une platine de support commune (16).

13. Commutateur à touche selon l'une quelconque des revendications précédentes, **caractérisé en ce que** le commutateur à touche (10) est en outre entouré d'un écran (24) pour le protéger contre une lumière extérieure, au moins dans la région de l'émetteur (12) et/ou du récepteur (14).

14. Dispositif de commande pour un appareil ménager électronique, comportant au moins un commutateur à touche tactile selon l'une quelconque des revendications 1 à 13.

15. Dispositif de commande selon la revendication 14, **caractérisé en ce que** plusieurs commutateurs à touche tactile selon l'une quelconque des revendications 1 à 13 sont combinés en un élément à touches.
